# EUROPEAN PATENT SPECIFICATION

(11) **EP 3 365 895 B1**
(45) Date of publication and mention of the grant of the patent: **08.03.2023**
(21) Application number: 16840368.1
(22) Date of filing: 11.10.2016
(51) Int. Cl.: G11C 19/28, G09G 3/36

(54) **SHIFT REGISTER UNIT, METHOD FOR DRIVING THE SAME, RELATED GATE DRIVER CIRCUIT, AND RELATED SEMICONDUCTOR DEVICE**
SCHIEBEREGISTEREINHEIT, VERFAHREN ZUR ANSTEUERUNG DAVON, ZUGEHÖRIGE GATE-TREIBERSCHALTUNG UND ZUGEHÖRIGES HALBLEITERBAUELEMENT
UNITÉ REGISTRE À DÉCALAGE, SON PROCÉDÉ DE COMMANDE, CIRCUIT D'ATTAQUE DE GRILLE ASSOCIÉ ET DISPOSITIF À SEMI-CONDUCTEUR ASSOCIÉ

(30) Priority: 19.10.2015 CN 201510679991
(43) Date of publication of application: 29.08.2018
(73) Proprietor: BOE Technology Group Co., Ltd., Beijing 100015 (CN); Beijing BOE Display Technology Co., Ltd., Beijing 100176 (CN)
(72) Inventor: YU, Haifeng, Beijing 100176 (CN); HUANG, Haiqin, Beijing 100176 (CN); WANG, Junwei, Beijing 100176 (CN)
(74) Representative: Cohausz & Florack
(86) International application number: PCT/CN2016/101789
(87) International publication number: WO 2017/067406

(56) References cited:
- CN-A- 103 474 017
- CN-A- 104 252 853
- CN-A- 104 616 617
- CN-A- 104 700 805
- CN-A- 104 715 733
- CN-A- 104 810 003
- CN-A- 105 185 412
- CN-U- 205 028 635
- US-A1- 2015 243 367

## Description

### CROSS-REFERENCES TO RELATED APPLICATIONS

This PCT patent application claims priority of Chinese Patent Application No. 201510679991.5, filed on October 19, 2015.

### TECHNICAL FIELD

The present invention generally relates to the display technologies and, more particularly, relates to a shift register unit, a method for driving the shift register unit, a related gate driver circuit, and a related semiconductor device.

### BACKGROUND

As liquid crystal display (LCD) devices advance, LCD devices with high resolution and narrow bezel become a main trend in the development of LCD devices. The use of gate shift register units in display panels is an important means to realize narrow bezel and high resolution in LCD devices.

Drivers of a thin film transistor-liquid crystal display (TFT-LCD) mainly include gate driver circuits and data driving circuits. A gate driver circuit mainly includes multiple levels of shift register units and signal lines connecting each shift register unit. The shift register unit of each level is connected to a gate line. The output signals of shift register units are used to scan and drive the pixel TFTs row by row.

In a conventional shift register unit, an enhanced resetting control module is used to reset the voltage at the node (referred as PU) connected to the control terminal of an output control module. The enhanced resetting control module often includes a plurality of transistors. The plurality of transistors takes up an undesirably large layout area in the corresponding shift register unit.

Chinese patent application CN 104 715 733 A discloses a shifting register unit, a gating driving circuit, a display device and a driving method for the shifting register unit. The shifting register unit comprises an input module for controlling a level of a pull-up control node according to a signal of a first signal input end, a pull-up module for outputting a local-stage output signal from a local-stage output end according to a signal of a second clock signal end and the level of the pull-up control node, a pull-down module for pulling down the level of the pull-up control node and the signal of the local-stage output end to low level according to a signal of a third clock signal end, and a resetting module for resetting the level of the pull-up control node according to a signal of a second signal input end and pulling down the level of the local-stage output end to a low level.

### BRIEF SUMMARY

The invention is set to the amended set of claims.

### BRIEF DESCRIPTION OF THE DRAWINGS

The following drawings are merely examples for illustrative purposes and are not intended to limit the scope of the present disclosure.
Figure 1 illustrates a circuit diagram of a conventional shift register unit;
Figure 2 illustrates a timing diagram of certain signals and levels of certain nodes in the conventional shift register unit illustrated in Figure 1;
Figure 3 illustrates a block diagram of an exemplary shift register unit of the present disclosure;
Figure 4 illustrates a block diagram of another exemplary shift register unit of the present disclosure;
Figure 5 illustrates a circuit diagram of an exemplary shift register unit according to an embodiment of the present disclosure; and
Figure 6 illustrates a timing diagram of certain signals and levels of certain nodes in the shift register unit illustrated in Figure 5.

### DETAILED DESCRIPTION

For those skilled in the art to better understand the technical solution of the invention, reference will now be made in detail to exemplary embodiments of the invention, which are illustrated in the accompanying drawings. Wherever possible, the same reference numbers will be used throughout the drawings to refer to the same or like parts.

In a shift register unit, when the node (referred as PU) connected to the control terminal of an output control module outputs a high voltage, the output control module may be turned on or connected. The output control module thus outputs a high-level shift driving signal. To prevent the output control module from outputting high level signals for more than once during one frame, after the output control module outputs a high-level shift driving signal, it is necessary to reset the voltage at PU to a low level. To prevent the voltage at PU from being pulled to a high level in one frame, e.g., caused by leakage current from modules (for example, input module) connected to the node PU, it is often necessary to keep resetting the voltage at PU in one frame.

To implement the resetting function, an enhanced resetting module and a control module for the enhanced resetting module are often arranged to reset the voltage at node PU. The control module for the enhanced resetting module can also be referred as an enhanced resetting control module. When the output control module outputs a high-level shift pulse signal, the enhanced resetting control module turns off the enhanced resetting module to avoid the enhanced resetting module from affecting the output control module. After one resetting process, the enhanced resetting control module turns on the enhanced resetting module to reset or enhance the resetting process of the voltage at node PU.

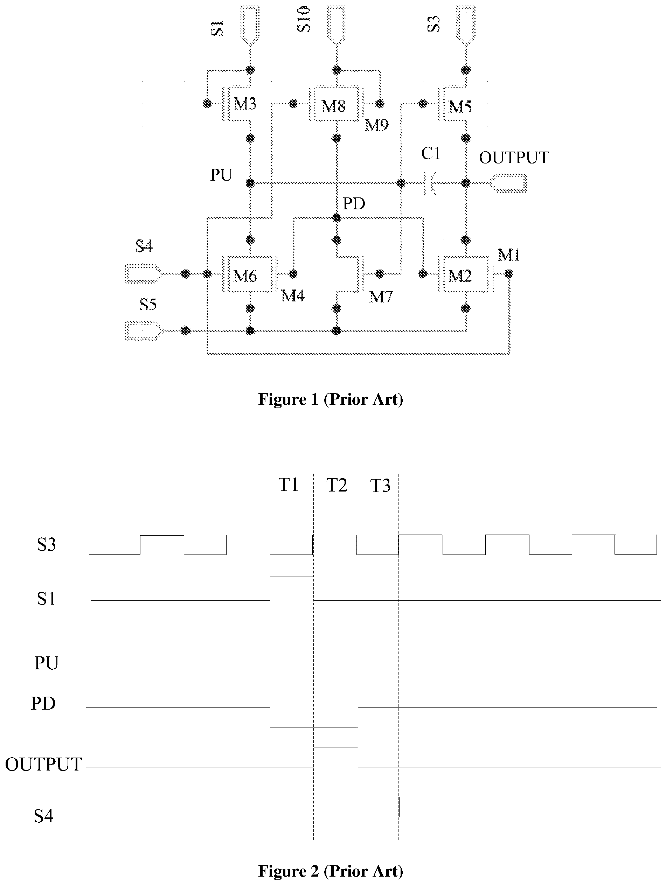

The exemplary structure of a conventional shift register unit is shown in Figure 1. The shift register unit includes nine N-type transistors, i.e., M1-M9, and a capacitor C1. The shift register unit also includes input terminals S3, S10, S1, S4, and S5. The operation of the shift register unit shown in Figure 1 can be illustrated by Figure 2. In the driving process, a clock signal is applied on the input terminal S3, a high-level signal is applied on the input signal S10, and a low-level signal is applied on the input terminal S5. A high-level pulse signal is applied on the input terminals S1 and S4 at different times or phases.

In the first phase T1, a pulse signal is applied on the input terminal S1, and a low-level signal is applied on the input terminal S4. At this time, the transistor M3 is turned on, and the voltage at node PU is pulled up. The transistors M5 and M7 are turned on. Because a low-level signal is applied on the input terminal S3, the driving signal output terminal OUTPUT outputs a low-level signal. Because the transistor M7 is turned on, the voltage at node PD may be a low-level signal, which turns off the transistors M2 and M4. That is, the width to length ratio of the channel in transistor M7 may be greater than the width to length ratio of the channel in transistor M9, the transistor M7 thus has a stronger ability to pull down. In addition, because a low-level voltage is applied on the input terminal S4, transistors M1 and M6 are turned off. The gate electrode and the source electrode of transistor M9 are connected, and are both connected to input terminal S10, transistor M9 is thus kept on in all phases.

In the second phase T2, a low-level signal is applied on input terminals S1 and S4. At this time, transistors M5 and M7 are kept on, and except for transistor M9, all other transistors are turned off. Because a high-level signal is applied on the input terminal S3, the driving signal output terminal OUTPUT outputs a high-level signal. Because a high-level voltage is applied on the second terminal of the capacitor C1, the voltage at node PU undergoes an instantaneous change or increase.

In the third phase T3, a low-level signal is applied on the input terminal S1 to turn off transistor M3. A high-level signal is applied on the input terminal S4. At this time, transistors M6, M8, and M1 are turned on such that the voltage at node PU and the voltage outputted by the driving signal output terminal OUTPUT are pulled down. Because the voltage at node PU is pulled down, transistor M7 is turned off, and the voltage at node PD is increased. Transistors M4 and M2 are turned on. After transistors M4 and M2 are turned on, the voltage at node PU stays at a low-level, and transistors M7, M2 and M4 are kept on. Enhanced resetting of node PU can be implemented.

In the process described above, transistors M2 and M4 are used for enhanced resetting of the voltage at node PU, and functions as an enhanced resetting module. Transistors M7, M8, and M9 are used for enhanced resetting control functions, and together function as an enhanced resetting control module. To arrange such enhanced resetting control module or transistors require an undesirably large number of transistors in the shift register unit, and the enhanced resetting control module or transistors take up an undesirably large layout area.

One aspect of the present disclosure provides a shift register unit. In an embodiment of the present disclosure, the shift register unit applies enhanced resetting functions to the first node PU without an enhanced resetting control module. Thus, a smaller layout area is needed for the shift register unit. It is also easier for the display device incorporating the disclosed shift register unit to implement narrower bezel.

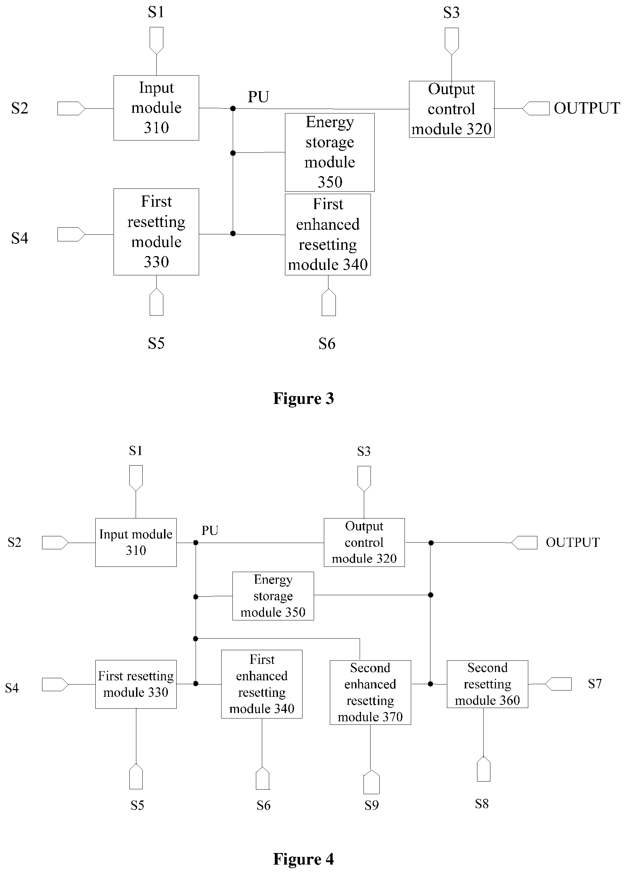

As shown in Figure 3, the shift register unit includes an input module 310, an output control module 320, a resetting module 330, an enhanced resetting module 340, and an energy storage unit 350. The shift register unit also includes a driving signal output terminal OUTPUT, a first input terminal S1, a second input terminal S2, a third input terminal S3, a fourth input terminal S4, a fifth input terminal S5, and a sixth input terminal S6. A first terminal of the power storage module 350 is connected to a first node PU.

The input module 310 is connected to the first node PU, the first input terminal S1, and the second input terminal S2. The input module 310 is turned on when the second input terminal S2 inputs an effective turn-on signal, i.e., with an effective voltage level, such that the input module 310 allows the pulse signal applied on the first input terminal S 1 to be written into the first node PU. In this disclosure, an effective turn-on signal refers to a suitable or effective voltage with an appropriate level to turn on or enable a corresponding module or part. In some examples, the effective turn-on signal of a module/part is the effective turn-on signal/voltage of the module/part. In this disclosure, the "effective turn-on signal/voltage" is interchangeable with the "turn-on signal/voltage". The voltage at the first node PU thus is set to be a first level. Meanwhile, the input module 310 charges the energy storage module 350 through the first terminal of the energy storage module 350. The level of the pulse signal is the first level.

The output control module 320 is connected to the first node PU, the third input terminal S3, and the shift driving signal output terminal OUTPUT. The output control module 320 is configured to control the shift driving signal output terminal OUTPUT to output a shift driving signal based on a first clock signal applied on the third input terminal S3, when the voltage at the first node PU is of the first level.

The first resetting module 330 is connected to the first node PU, the fourth input terminal S4, and the fifth input terminal S5. Controlled by the resetting signal applied by the fourth input terminal S4, the first resetting module 330 is configured to reset the voltage at the first node PU to a second level based on the voltage applied by the fifth input terminal S5. The first resetting module 330 also discharges to the first terminal of the energy storage module 350. The resetting signal applied by the fourth input terminal S4 is of the first level, and the voltage applied by the fifth input terminal be of the second level. The second level is lower than the first level.

The first enhanced resetting module 340 is connected to the first node PU and a sixth input terminal S6. The first enhanced resetting module 340 is configured to set the voltage at the first node PU to the voltage applied by the sixth input terminal S6 when the voltage at the first node PU is of the second level and the input module 310 is turned off.

The disclosed shift register unit implements enhanced resetting functions to the first node PU without an enhanced resetting control module. Compared to a conventional shift register unit, which requires an enhanced resetting control module, a smaller layout area is needed for the disclosed shift register unit. It is thus easier for the display device incorporating the disclosed shift register unit to implement narrower bezel.

In some examples, the fifth input terminal S5 and the sixth terminal S6 be a same input terminal or share one input terminal. When the fifth input terminal S5 is applied with a voltage of the second level, the sixth input terminal S6 also is applied with a voltage of the second level. When a voltage of the second level is not applied on the fifth input terminal S5, a voltage of the second level is also not needed to be applied on the sixth input terminal S6. Thus, arranging the fifth input terminal S5 and the sixth input terminal S6 to be the same input terminal would not affect the output of the shift register unit, and the number of input terminals can be reduced. The number of signal lines used to drive the shift register unit can be reduced. It may be easier to arrange the layout of the corresponding gate driver circuit. The fabrication of the corresponding gate driver circuit may be easier.

Figure 4 illustrates another disclosed exemplary shift register unit. As shown in Figure 4, in some examples, a second terminal of the energy storage module 350 in the disclosed shift register unit also is connected to the shift driving signal output terminal OUTPUT.

The disclosed shift register unit further includes a second resetting module 360, a seventh input terminal S7, and an eighth input terminal S8. The second resetting module 360 is connected to the shift driving signal output terminal OUTPUT, the seventh input terminal S7, and the eighth input terminal S8. The second resetting module 360 is turned on when the seventh input terminal S7 is applied with a voltage of the first level and the eighth input terminal S8 is applied with a voltage of the second level.

Thus, when the voltage of the shift driving signal output terminal OUTPUT is a shift pulse of the first level, the voltage at the first terminal of the energy storage module 350 undergoes an instantaneous change, i.e., changing to a higher voltage or to a lower voltage. For example, if the first level is a high level, the voltage at the first terminal of the energy storage module 350 instantaneously changes to a voltage of a higher level. If the first level is a low level, the voltage at the first terminal of the energy storage module 350 instantaneously changes to a voltage of a lower level. That is, the voltage at the first node PU instantaneously changes to a higher voltage or a lower voltage. Thus, the output control module 320 has improved turn-on performance. The output control module 320 more accurately controls the shift driving signal output terminal OUTPUT to output the shift driving signal.

In some examples, the seventh input terminal S7 and the fourth input terminal S4 is one input terminal or share a same input terminal. Accordingly, the effective turn-on level of the second resetting module 360 is the same or consistent with the voltage level of the resetting signal applied on the first resetting module 330. For example, the effective turn-on level of the second resetting module 360 and the voltage level of the resetting signal both be the first level. In this way, fewer signal lines is used in the shift register unit. The layout area of the corresponding gate driver circuit is reduced.

In some examples, the second resetting module 360 includes a transistor. For illustrative purposes, the transistor contained in the second resetting module 360 is a first transistor M1. The gate electrode of the first transistor M1 is connected to the seventh input terminal S7. The source electrode of the first transistor M1 is connected to the shift driving signal output terminal OUTPUT. The drain electrode of the first transistor M1 is connected to the eighth input terminal S8. The turn-on level of the first transistor M1 is the first level. In the present disclosure, the terms "first", "second", and the like are merely for illustrative purposes and do not indicate any difference in functions or structures.

As shown in Figure 4, in some examples, the disclosed shift register unit further includes a second enhanced resetting module 370 and a ninth input terminal S9. The second enhanced resetting module 370 is connected to the first node PU, the ninth input terminal S9, and the shift driving signal output terminal OUTPUT. The second enhanced resetting module 370 is configured to reset the voltage outputted by the shift driving signal output terminal OUTPUT to the second level when the voltage at the first node PU is of the second level and the ninth input terminal S9 is applied with a voltage of the second level.

Specifically, the second enhanced resetting module 370 includes a P-type second transistor M2. The gate electrode of the second transistor M2 is connected to the first node PU. The drain electrode of the second transistor M2 is connected to the shift driving signal output terminal OUTPUT. The source electrode of the second transistor M2 is connected to the ninth input terminal S9. The turn-on level of the second transistor M2 is the second level.

In some examples, the ninth input terminal S9 shares the same input terminal with one or more of the fifth input terminal S5, the sixth input terminal S6, and the eighth input terminal S8. Thus, the number of signal lines for driving the shift register unit may be reduced. In some examples, the fifth input terminal S5, the sixth input terminal S6, the eighth input terminal S8, and the ninth input terminal S9 is or shares a VSS terminal for providing a voltage of a second level.

In some examples, the input module 310 includes an N-type third transistor M3. The gate electrode of the third transistor M3 is connected to the second input terminal S2, and the source electrode of the third transistor M3 is connected to the first input terminal S1. Alternatively, the gate electrode of the third transistor M3 is connected to the first input terminal S1, and the source electrode of the third transistor M3 is connected to the second input terminal S2. The drain electrode of the third transistor M3 is connected to the first node PU. The turn-on level of the third transistor M3 is the first level.

In some examples, the first enhanced resetting module 340 includes a P-type fourth transistor M4. The gate electrode and the drain electrode of the fourth transistor M4 is connected to the first node PU. The source electrode of the fourth transistor M4 is connected to the sixth input terminal S6. The width to length ratio of the channel of the fourth transistor M4 is less than the width to length ratio of the channel of the third transistor M3. The turn-on level of the fourth transistor M4 is the second level.

The reason for applying a P-type second transistor M2 and a P-type fourth transistor M4 includes the follows. For example, the P-type second transistor M2 and the P-type fourth transistor M4 may ensure the voltage level at the first node PU maintain stable in a first phase and in a second phase of the operation (described in detail in the description of the method for driving a shift register unit). Also, in the third phase, the P-type second transistor M2 and the P-type fourth transistor M4 applies enhanced resetting functions on the first node PU and the shift driving signal output terminal OUTPUT. Thus, the voltage levels at the first node and the shift driving signal output terminal OUTPUT is desirably pulled down.

In some examples, the output control module 320 includes a fifth transistor M5. The source electrode of the fifth transistor M5 is connected to the third input terminal S3. The gate electrode of the fifth transistor M5 is connected to the first node PU. The drain electrode of the fifth transistor M5 is connected to the shift driving signal output terminal OUTPUT. The turn-on level of the fifth transistor M5 is the first level.

In some examples, the first resetting module 330 includes a sixth transistor M6. The source electrode of the sixth transistor M6 is connected to the first node PU. The drain electrode of the sixth transistor M6 is connected to the fifth input terminal S5. The gate electrode of the sixth transistor M6 is connected to the fourth input terminal S4. The turn-on level of the sixth transistor M6 is the first level.

In some examples, the first input terminal S1 and the second input terminal S2 is a same input terminal. The effective turn-on level of the input module 310 is the first level. When the input module 310 needs to be turned on, the first input terminal S1 and the second input terminal S2 both need to be applied with a voltage of the first level. When the input module 310 needs not be turned on, neither of the first input terminal S1 and the second input terminal S2 need to be applied with a voltage of the first level. Thus, the first input terminal S1 and the second input terminal S2 share or are combined to be a same signal input terminal. The normal operation of the shift register would not be impaired, and the number of signal lines for driving the shift register unit may be reduced.

It some examples, the energy storage module 350 is a capacitor or other suitable devices for storing energy.

In some examples, the first level is a high level, and the second level is a low level. The first transistor M1, the third transistor M3, the fifth transistor M5, the sixth transistor M6 is N-type transistors. The second transistor M2 and the fourth transistor M4 is P-type transistors. In certain other examples, the first level is a low level, and the second level is a high level. The first transistor M1, the third transistor M3, the fifth transistor M5, the sixth transistor M6 is P-type transistors. The second transistor M2 and the fourth M4 transistor is N-type transistors. The types of transistors, and the arrangement of the first level and the second level is determined according to different applications and designs of the present disclosure, and should not be limited by the examples of the present disclosure.

It should be noted that, an N-type transistor may refer to a suitable transistor that can be turned on when the voltage applied thereon is higher than its threshold voltage, and a P-type transistor may refer to a suitable transistor that can be turned on when the voltage applied thereon is lower than its threshold voltage. The first level may refer to a voltage that is used to turn on an N-type transistor and turn off a P-type transistor, and the second level may refer to a voltage that is used to turn off an N-type transistor and turn on a P-type transistor. In some examples, the source electrode and the drain electrode of a transistor are interchangeable. It should be noted that, the modules used in the disclosed shift register unit should not be limited to the structures described above. In certain examples, the structures of some modules may vary according to different applications. For example, in some examples, the input module includes more than one transistors. It is only required that each module is able to implement a desired function. The specific structure of a module should not be limited to the examples of the present disclosure.

Another aspect of the present disclosure provides a method for driving a shift register unit. The method is used to drive the shift register units illustrated in Figures 3 and 4. The method includes the following steps.

In the first phase, a voltage of an effective turn-on level for the input module 310 is applied on the second input terminal S2 to turn on the input module 310. A pulse signal of the first level is applied on the first input terminal S1 so that the input module 310 sets the voltage at the first node PU to the first level. The input module 310 also charges the first terminal of the energy storage module 350.

In the second phase, when the voltage at the first node PU is of the first level, the output control module 320 is turned on. A first clock signal is applied on the third input terminal S3, to control the output control module 320 to output a shift driving signal through the shift driving signal output terminal OUTPUT.

In the third phase, a reset signal is applied on the fourth input terminal S4, and a voltage of the second level is applied on the fifth input terminal S5 so that the first resetting module 330 resets the voltage at the first node PU to the second level. The first resetting module 330 also discharges to the first terminal of the energy storage module 350. A voltage of the second level is applied on the sixth input terminal S6 so that the voltage at the first node PU is further reset to the voltage applied on the sixth input terminal, by the first enhanced resetting module 340.

In and after the third phase in the same frame, the voltage at the first node PU is of the second level. That is, the first enhanced resetting module 340 is turned on so that the first enhanced resetting module 340 further sets the voltage at the first node PU to be the voltage applied on the sixth input terminal S6. The operation of the process may repeat and the voltage at the first node PU may change accordingly in the next frame.

That is, in the first phase, the input module 310 is turned on to set the voltage at the first node PU to the first level and charge the energy storage module 350 at the same time. In the second phase, because the voltage at the first node PU starts at the first level, the output control module 320 is turned on. Meanwhile, the first clock signal is applied on the third input terminal S3, and the shift driving signal output terminal OUTPUT outputs the shift driving signal. In the third phase, the first resetting module 330 is turned on to pull down the voltage at the first node PU. The first enhanced resetting module 340 also is turned on to continuously pull down the voltage at the first node PU.

Thus, when the shift driving signal output terminal OUTPUT outputs the shift driving signal of the first level in the second phase, because the voltage at the first node PU is of the first level, the first enhanced resetting module 340 is turned off and the first enhanced resetting module 340 would not be affect the output control module 320 to output the shift driving signal. In the third phase, after the voltage at the first node PU is set to the second level by the first resetting module 330, the first enhanced resetting module 340 is kept on to prevent charge accumulation at the first node PU. The voltage at the first node PU thus would not change to the first level, which causes the output control module 320 to be turned on again. Thus, no enhanced resetting control module is needed for resetting the voltage at the first node PU. Compared to conventional technology, which requires an enhanced resetting control module in a shift register unit, a smaller layout area is required for the disclosed shift register unit. It is easier for the display device incorporating the disclosed shift register unit to implement a narrow bezel design.

When used to drive a shift register unit with a second resetting module 360, as shown in Figure 4, the disclosed method further includes the following step. For example, in the third phase, an effective turn-on signal for the second resetting module 360 is applied on the seventh input terminal S7, and a voltage of the second level is applied on the eighth input terminal S8, to reset the voltage outputted by the shift driving signal output terminal OUTPUT. By applying this step, the voltage outputted by the shift driving signal output terminal OUTPUT is set to the second level, so that the shift driving signal output terminal OUTPUT would not further output any shift driving signal.

The disclosed shift register unit and the method for driving the shift register unit are now illustrated in detail using the circuit diagram, certain signals for driving the shift register unit, and the level changes at certain nodes.

Assuming in this example, the first input terminal S1 and the second input terminal S2 share the same input terminal, represented by S1. The fifth input terminal S5, the sixth input terminal S6, the eighth input terminal S8, and the ninth input terminal S9 share the same input terminal, represented by S5. The seventh input terminal and the fourth input terminal S4 share the same input terminal, represented by S4. The first level is the high level, and the second level is the low level.

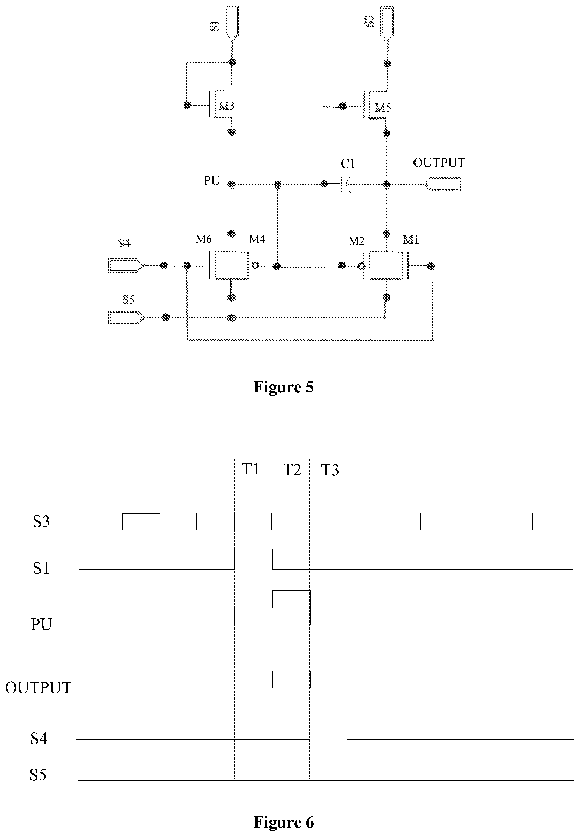

An exemplary structure of the shift register unit in an embodiment of the present invention is shown in Figure 5. The shift register unit includes six transistors M1, M2, M3, M4, M5, and M6, and a capacitor C1. The shift register unit also includes a third input terminal S3, a first input terminal S1, a fourth input terminal S4, and a fifth input terminal S5. The second transistor M2 and the fourth transistor M4 is P-type transistors. Other transistors is N-type transistors. The width to length ratio of the channel of the third transistor M3 is greater than the width to length ratio of the channel of the fourth transistor M4. The gate electrode of the second transistor M2, the drain electrode of the third transistor M3, the drain electrode and the gate electrode of the fourth transistor M4, the gate electrode of the fifth transistor M5, the source electrode of the sixth transistor M6, and a terminal of the capacitor C1 is connected to node PU.

The drain electrode of the first transistor M1, the source electrode of the second transistor M2, the source electrode of the fourth transistor M4, and the drain electrode of the sixth transistor M6 is connected to the fifth input terminal S5. The gate electrode of the first transistor M1 and the gate electrode of the sixth transistor M6 is connected to the fourth input terminal S4. The gate electrode and the source electrode of the third transistor M3 is connected to the first input terminal S1. The drain electrode of the second transistor M2 and the drain electrode of the fifth transistor M5 is connected to the shift driving signal output terminal OUTPUT. The gate electrode and the source electrode of the third transistor M3 is connected to the first input terminal S1. The source electrode of the fifth transistor M5 is connected to the third input terminal S3.

The second transistor M2 and the fourth transistor M4 is P-type transistors. The reason for applying a P-type second transistor M2 and a P-type fourth transistor M4 includes the follows. For example, the P-type second transistor M2 and the P-type fourth transistor M4 may ensure the voltage level at the first node PU maintain stable in a first phase and in a second phase of the operation. Also, in the third phase, the P-type second transistor M2 and the P-type fourth transistor M4 applies enhanced resetting functions on the first node PU and the shift driving signal output terminal OUTPUT. Thus, the voltage levels at the first node and the shift driving signal output terminal OUTPUT is desirably pulled down.

The method or operation to drive the shift register unit shown in Figure 5 may be illustrated in the timing diagram shown in Figure 6. In Figure 6, the operation of the shift register unit, from the first phase T1 to the third phase T3, may be illustrated.

In the first phase T1, a voltage of high level is applied on the first input terminal S1. At this time, the third transistor M3 is turned on and starts to charge the first node PU, which is connected to the capacitor C1. The voltage at the first node PU is set to be of a high level, and the fifth transistor M5 is turned on. Because the first clock signal applied on the third input terminal S3 is of low level, the voltage outputted by the shift driving signal output terminal OUTPUT is of low level. The voltage at the first node PU is of high level so that the second transistor M2 and the fourth transistor M4 is turned off. Meanwhile, a voltage of low level is applied on the fourth input terminal S4 so that the first transistor M1 and the sixth transistor M6 is turned off. It should be noted that, before the first phase T1, the voltage at the first node PU is of low level and the fourth transistor M4 is turned on. Because the width to length ratio of the channel of the third transistor M3 is greater than the width to length ratio of the channel of the fourth transistor M4, the third transistor M3 is still be able to charge the first node PU. The voltage at the first node PU is thus be charged to be of high level.

In the second phase T2, a voltage of low level is applied on the first input terminal S1 and the fourth input terminal S4 to turn off the third transistor M3, the sixth transistor M6, and the first transistor M1. Because the voltage at the first node PU is of high level, the fourth transistor M4 and the second transistor M2 is turned off to ensure the voltage at the first node PU would not be pulled down. That is, the voltage at the first node PU is high to keep the fifth transistor M5 on. Because the first clock signal applied on the first input terminal S3 is of high level, the voltage outputted by the shift driving signal output terminal OUTPUT is of high level. The shift driving signal output terminal OUTPUT outputs a high-level shift driving signal. The changing of voltage outputted by the shift driving signal output terminal OUTPUT to high level may cause the voltage at the first node PU to undergo an instantaneous change. The reasons for the instantaneous change may include that, the first node PU is floating, and the voltage difference between the two terminals of the capacitor C1 would remain the same, so that the voltage at the first node PU would increase in accordance with the increase of the voltage outputted by the shift driving signal output terminal OTUPUT. The increasing of voltage at the first node PU may ensure the shift driving signal output terminal OUTPUT outputs a high-level shift driving signal with improved stability.

In the third phase T3, a voltage of low level is applied on the first input terminal S1 to turn off the third transistor S3. Meanwhile, a voltage of high level is applied on the fourth input terminal S4 to turn on the sixth transistor M6 and the first transistor M1. Thus, the voltage at the first node PU and the voltage outputted by the shift driving signal output terminal OUTPUT is pulled down. The pulling down of the voltage at the first node PU enables the second transistor M2 and the fourth transistor M4 to be turned on. After the second transistor M2 and the fourth transistor M4 are turned on, the voltage at the first node PU is kept at a low level, so that the second transistor M2 and the fourth transistor M4 is kept on. The enhanced resetting of the voltage at the first node PU is realized.

As described above, in phases T1-T3, when the fourth input terminal S4 and the fifth input terminal S5 are provided with a voltage of low level, the first transistor M1 resets the voltage outputted by the shift driving signal output terminal OUTPUT. The first transistor M1 functions as the second resetting module. When the voltage at the first node PU is of low level and a voltage of low level is applied on the fifth input terminal S5, the second transistor M2 resets the voltage outputted by the shift driving signal output terminal OUTPUT, so that the enhanced resetting of the voltage outputted by the shift driving signal output terminal OUTPUT is realized. The second transistor M2 may function as the second enhanced resetting module. When a voltage of high level is applied on the first input terminal S1, the third transistor M3 writes the shift driving signal to the first node PU so that the voltage at the first node PU is set to be of high level. Meanwhile the third transistor M3 charges the capacitor C1. The third transistor M3 functions as the input module.

When the voltage at the first node PU is of low level and the input terminal 310 is turned off, the fourth transistor M4 resets the voltage at the first node PU to be the voltage applied on the sixth input terminal S6. The fourth transistor M4 functions as the first enhanced resetting module. When the voltage at the first node PU is of high level, the fifth transistor M5 outputs the high-level shift driving signal according to the first clock signal. The fifth transistor M5 functions as the output control module. The resetting signal of the first level is applied on the fourth input terminal S4 to control the sixth transistor M6 to set the voltage at the first node PU to be the voltage applied on the fifth input terminal S5. The voltage applied on the fifth input terminal S5, which is of the second level. The voltage at the first node PU is reset. The sixth transistor M6 functions as the first resetting module. The capacitor C1 is used to store energy, e.g., electric charges. The capacitor C1 functions as the energy storing module.

Referring to Figures 1 and 4, compared to conventional technology, the shift register unit of the present disclosure may reduce the number of transistors by three, i.e., eliminating transistors M7, M8, and M9. Thus, a smaller layout area is required for the disclosed shift register unit.

Another aspect of the present disclosure provides a gate driver circuit. The gate driver circuit may include a plurality of cascading shift register units. The shift register unit may be any one of the disclosed shift register unit. It should be noted that, in some examples, except for the first-level shift register unit and the last-level shift register unit, the first input terminal of each shift register unit may be connected to the shift driving signal output terminal of the shift register unit of a previous level, to receive the shift driving signal outputted by the shift register unit of the previous level. The shift driving signal output terminal of each shift register unit may be connected to the first input terminal of the shift register unit of a next level, to output the shift driving signal to the shift register unit of the next level.

Also, the shift driving signal output terminal may also be connected to the fourth input terminal of the shift register unit of the previous level to reset the shift register unit of the previous level. The first input terminal of the first-level shift register unit may be connected to a starting signal. Besides the first input terminal and the fourth input terminal, other input terminals of a shift register unit may each be connected to a corresponding signal line. Details may be referred to previous examples and are not repeated herein.

Another aspect of the present disclosure provides a semiconductor device. The semiconductor device may include one or more of the disclosed gate driver circuits. In some examples, the semiconductor device may be a display apparatus.

The display apparatus may be an electronic paper, a mobile phone, a tablet computer, a television, a monitor, a laptop computer, a digital frame, a navigation device, or any products or structures with display functions.

It should be noted that, the display apparatus may be a liquid crystal display device or other suitable types of display devices.

The disclosed shift register unit has several advantages. For example, the first resetting module may be connected to the first node and the sixth input terminal, to set the voltage at the first node to be the voltage applied on the sixth input terminal when the voltage at the first node is of the second level and the input module is turned off. Thus, when the output control module is outputting the shift driving signal, because the voltage at the first node is of the first level, the first resetting module would not be turned on. The outputting of the shift driving signal would not be adversely affected. When the voltage at the first node is set to the second level, the first enhancing module may be kept on. By applying a voltage of the second level on the sixth input terminal, charges would not accumulate at the first node, and the voltage at the first node would not change to the first level again. Thus, no enhanced resetting control module is needed to implement the enhanced resetting function on the voltage at the first node. Compared to conventional technology, which often includes an enhanced resetting control module in a shift register unit, a smaller layout area is needed for the disclosed shift register unit. It is thus easier to realize narrow bezel on the display device incorporating the disclosed shift register units.

It should be understood that the above embodiments disclosed herein are exemplary only and other modifications, equivalents, or improvements to the disclosed embodiments, which are obvious to those skilled in the art, are intended to be encompassed within the scope of the present disclosure as defined by the scope of the claims.

## Claims

1. A shift register unit, comprising: an input module (310), a first resetting module (330), an energy storage module (350), a first enhanced resetting module (340), an output control module (320), a first input terminal (S 1), a second input terminal (S2), a third input terminal (S3), a fourth input terminal (S4), a fifth input terminal (S5), a sixth input terminal (S6), a shift driving signal output terminal (OUTPUT), and a first node (PU), a second resetting module (360), a seventh input terminal (S7), and an eighth input terminal (S8), a second enhanced resetting module (370) and a ninth input terminal (S9), wherein:
a first terminal of the energy storage module (350) is connected to the first node (PU) and a second terminal of the energy storage module (350) is connected to the shift driving signal output terminal (OUTPUT);
the input module (310) is connected to the first node (PU), the first input terminal (S1), and the second input terminal (S2);
the output control module (320) is connected to the first node (PU), the third input terminal (S3), and the shift driving signal output terminal (OUTPUT);
the first resetting module (330) is connected to the first node (PU), the fourth input terminal (S4), and the fifth input terminal (S5); and
the first enhanced resetting module (340) is connected to the first node (PU) and the sixth input terminal (S6), the first enhanced resetting module (340) comprises a fourth transistor (M4), being P-type, a gate electrode and a drain electrode of the fourth transistor (M4) being connected to the first node (PU), a source electrode of the fourth transistor (M4) being connected to the sixth input terminal (S6),
the input module (310) comprises a third transistor (M3), being N-type, a gate electrode of the third transistor (M3) being connected to the second input terminal (S2), and a source electrode of the third transistor (M3) being connected to the first input terminal (S 1);or the gate electrode of the third transistor (M3) being connected to the first input terminal (S 1), and the source electrode of the third transistor (M3) being connected to the second input terminal (S2), a drain electrode of the third transistor (M3) being connected to the first node (PU), the output control module (320) comprises a fifth transistor (M5), being N-type, a source electrode of the fifth transistor (M5) being connected to the third input terminal (S3), a gate electrode of the fifth transistor (M5) being connected to the first node (PU), a drain electrode of the fifth transistor (M5) being connected to the shift driving signal output terminal (OUTPUT), the first resetting module (330) comprises a sixth transistor (M6), being N-type, a source electrode of the sixth transistor (M6) being connected to the first node (PU), a drain electrode of the sixth transistor (M6) being connected to the fifth input terminal (S5), a gate, electrode of the sixth transistor (M6) being connected to the fourth input terminal (S4), the first input terminal (S 1) and the second input terminal (S2) are a same input terminal; and
the energy storage unit is a capacitor,
the second resetting module (360) being connected to the shift driving signal output terminal (OUTPUT), the seventh input terminal, and the eighth input terminal, wherein:
the second resetting module (360) comprises a first transistor (M1), being N-type, a gate electrode of the first transistor (M1) being connected to the seventh input terminal, a source electrode of the first transistor (M1) being connected to the shift driving signal output terminal (OUTPUT), and a drain electrode of the first transistor (M1) being connected to the eighth input terminal;
the second enhanced resetting module (370) is connected to the first node (PU), the ninth input terminal, and the shift driving signal output terminal (OUTPUT); the second enhanced resetting module (340) comprises a second transistor (M2), being P-type, a gate electrode of the second transistor (M2) being connected to the first node (PU), a drain electrode of the second transistor (M2) being connected to the shift driving signal output terminal (OUTPUT), a source electrode of the second transistor (M2) being connected to the ninth input terminal, and, a width to length ratio of the channel of the fourth transistor (M4) is less than a width to length ratio of the channel of the third transistor (M3)
wherein the seventh input terminal and the fourth input terminal (S4) are a same input terminal and
the fifth input terminal, the sixth input terminal, the eight input terminal and the ninth input terminal are a same input terminal.

2. A method for driving the shift register unit according to claims 1, comprising:
in a first phase, applying a voltage of an turn-on level for the input module (310) on the second input terminal (S2) to turn on the input module (310), and applying a pulse signal of the first level on the first input terminal (S 1) so that the input module (310) sets the voltage at the first node (PU) to the first level, and the input module (310) charging the first terminal of the energy storage module (350);
in a second phase, when the voltage at the first node (PU) is of the first level, turning on the output control module (320), applying a first clock signal on the third input terminal (S3) to control the output control module (320) to output a shift driving signal through the shift driving signal output terminal (OUTPUT); and
in a third phase, applying a reset signal on the fourth input terminal (S4) and applying a voltage of the second level on the fifth input terminal (S5) so that the first resetting module (330) resets the voltage at the first node (PU) to the second level, and the first resetting module (330) discharging to the first terminal of the energy storage module (350),
wherein in and after the third phase in a same frame, the voltage at the first node (PU) is of the second level, turning on the first enhanced resetting module (340) so that the first enhanced resetting module (340) sets the voltage at the first node (PU) to be the voltage applied on the sixth input terminal (S6).

3. A gate driver circuit, comprising a plurality of cascading shift register units according to claim 1.

4. A semiconductor device, comprising one or more of the gate driver circuits according to claim 3.

## Patentansprüche

1. Schieberegistereinheit, aufweisend: ein Eingangsmodul (310), ein erstes Rücksetzmodul (330), ein Energiespeichermodul (350), ein erstes verbessertes Rücksetzmodul (340), ein Ausgangssteuermodul (320), einen ersten Eingangsanschluss (S1), einen zweiten Eingangsanschluss (S2), einen dritten Eingangsanschluss (S3), einen vierten Eingangsanschluss (S4), einen fünften Eingangsanschluss (S5), einen sechsten Eingangsanschluss (S6), einen Schiebeansteuerungssignal-Ausgangsanschluss (OUTPUT) und einen ersten Knoten (PU), ein zweites Rücksetzmodul (360), einen siebten Eingangsanschluss (S7) und einen achten Eingangsanschluss (S8), ein zweites verbessertes Rücksetzmodul (370) und einen neunten Eingangsanschluss (S9), wobei:
ein erster Anschluss des Energiespeichermoduls (350) mit dem ersten Knoten (PU) verbunden ist und ein zweiter Anschluss des Energiespeichermoduls (350) mit dem Schiebeansteuerungssignal-Ausgangsanschluss (OUTPUT) verbunden ist;
das Eingangsmodul (310) mit dem ersten Knoten (PU), dem ersten Eingangsanschluss (S1) und dem zweiten Eingangsanschluss (S2) verbunden ist;
das Ausgangssteuermodul (320) mit dem ersten Knoten (PU), dem dritten Eingangsanschlusses (S3) und dem Schiebeansteuerungssignal-Ausgangsanschluss (OUTPUT) verbunden ist;
das erste Rücksetzmodul (330) mit dem ersten Knoten (PU), dem vierten Eingangsanschluss (S4) und dem fünften Eingangsanschluss (S5) verbunden ist; und
das erste verbesserte Rücksetzmodul (340) mit dem ersten Knoten (PU) und dem sechsten Eingangsanschluss (S6) verbunden ist, wobei das erste verbesserte Rücksetzmodul (340) einen vierten Transistor (M4) vom p-Typ aufweist, wobei eine Gate-Elektrode und eine Drain-Elektrode des vierten Transistors (M4) mit dem ersten Knoten (PU) verbunden sind und eine Source-Elektrode des vierten Transistors (M4) mit dem sechsten Eingangsanschluss (S6) verbunden ist,
das Eingangsmodul (310) einen dritten Transistor (M3) vom n-Typ aufweist, wobei eine Gate-Elektrode des dritten Transistors (M3) mit dem zweiten Eingangsanschluss (S2) verbunden ist und eine Source-Elektrode des dritten Transistors (M3) mit dem ersten Eingangsanschluss (S1) verbunden ist;
oder die Gate-Elektrode des dritten Transistors (M3) mit dem ersten Eingangsanschluss (S1) und die Source-Elektrode des dritten Transistors (M3) mit dem zweiten Eingangsanschluss (S2) verbunden ist, wobei eine Drain-Elektrode des dritten Transistors (M3) mit dem ersten Knoten (PU) verbunden ist, das Ausgangssteuermodul (320) einen fünften Transistor (M5) aufweist, der vom n-Typ ist, wobei eine Source-Elektrode des fünften Transistors (M5) mit dem dritten Eingangsanschluss (S3) verbunden ist und eine Gate-Elektrode des fünften Transistors (M5) mit dem ersten Knoten (PU) verbunden ist, eine Drain-Elektrode des fünften Transistors (M5) mit dem Schiebeansteuerungssignal-Ausgangsanschluss (OUTPUT) verbunden ist, das erste Rücksetzmodul (330) einen sechsten Transistor (M6) vom n-Typ aufweist, wobei eine Source-Elektrode des sechsten Transistors (M6) mit dem ersten Knoten (PU) verbunden ist, eine Drain-Elektrode des sechsten Transistors (M6) mit dem fünften Eingangsanschluss (S5) verbunden ist, eine Gate-Elektrode des sechsten Transistors (M6) mit dem vierten Eingangsanschluss (S4) verbunden ist, der erste Eingangsanschluss (S1) und der zweite Eingangsanschluss (S2) ein und derselbe Eingangsanschluss sind; und
die Energiespeichereinheit ein Kondensator ist,
das zweite Rücksetzmodul (360) mit dem Schiebeansteuerungssignal-Ausgangsanschluss (OUTPUT), dem siebten Eingangsanschluss und dem achten Eingangsanschluss verbunden ist, wobei:
das zweite Rücksetzmodul (360) einen ersten Transistor (M1) vom n-Typ aufweist, wobei eine Gate-Elektrode des ersten Transistors (M1) mit dem siebten Eingangsanschluss verbunden ist, eine Source-Elektrode des ersten Transistors (M1) mit dem Schiebeansteuerungssignal-Ausgangsanschluss (OUTPUT) verbunden ist und eine Drain-Elektrode des ersten Transistors (M1) mit dem achten Eingangsanschluss verbunden ist;
das zweite verbesserte Rücksetzmodul (370) mit dem ersten Knoten (PU), dem neunten Eingangsanschluss und dem Schiebeansteuerungssignal-Ausgangsanschluss (OUTPUT) verbunden ist; das zweite verbesserte Rücksetzmodul (340) einen zweiten Transistor (M2) aufweist, der vom p-Typ ist, wobei eine Gate-Elektrode des zweiten Transistors (M2) mit dem ersten Knoten (PU) verbunden ist, eine Drain-Elektrode des zweiten Transistors (M2) mit dem Schiebeansteuerungssignal-Ausgangsanschluss (OUTPUT) verbunden ist, eine Source-Elektrode des zweiten Transistors (M2) mit dem neunten Eingangsanschluss verbunden ist und ein Verhältnis von Breite zu Länge des Kanals des vierten Transistors (M4) kleiner ist als ein Verhältnis von Breite zu Länge des Kanals des dritten Transistors (M3),
wobei der siebte Eingangsanschluss und der vierte Eingangsanschluss (S4) ein und derselbe Eingangsanschluss sind und
der fünfte Eingangsanschluss, der sechste Eingangsanschluss, der achte Eingangsanschluss und der neunte Eingangsanschluss ein und derselbe Eingangsanschluss sind.

2. Verfahren zum Ansteuern der Schieberegistereinheit nach Anspruch 1, umfassend:
in einer ersten Phase, Anlegen einer Spannung eines Einschaltpegels für das Eingangsmodul (310) an den zweiten Eingangsanschluss (S2), um das Eingangsmodul (310) einzuschalten, und Anlegen eines Impulssignals des ersten Pegels an den ersten Eingangsanschluss (S1), so dass das Eingangsmodul (310) die Spannung an dem ersten Knoten (PU) auf den ersten Pegel setzt, und das Eingangsmodul (310) den ersten Anschluss des Energiespeichermoduls (350) lädt;
in einer zweiten Phase, wenn die Spannung an dem ersten Knoten (PU) den ersten Pegel hat, Einschalten des Ausgangssteuermoduls (320), Anlegen eines ersten Taktsignals an den dritten Eingangsanschluss (S3), um das Ausgangssteuermodul (320) so zu steuern, dass es ein Schiebeansteuerungssignal über den Schiebeansteuerungssignal-Ausgangsanschluss (OUTPUT) ausgibt; und
in einer dritten Phase, Anlegen eines Rücksetzsignals an den vierten Eingangsanschluss (S4) und Anlegen einer Spannung des zweiten Pegels an den fünften Eingangsanschluss (S5), so dass das erste Rücksetzmodul (330) die Spannung an dem ersten Knoten (PU) auf den zweiten Pegel zurücksetzt, und das erste Rücksetzmodul (330) sich an den ersten Anschluss des Energiespeichermoduls (350) entlädt,
wobei in und nach der dritten Phase in einem und demselben Rahmen die Spannung an dem ersten Knoten (PU) den zweiten Pegel hat, das erste verbesserte Rücksetzmodul (340) eingeschaltet wird, so dass das erste verbesserte Rücksetzmodul (340) die Spannung an dem ersten Knoten (PU) auf die Spannung setzt, die an dem sechsten Eingangsanschluss (S6) angelegt ist.

3. Gate-Treiberschaltung, mehrere kaskadierende Schieberegistereinheiten nach Anspruch 1 aufweisend.

4. Halbleiterbauelement, eine oder mehrere der Gate-Treiberschaltung nach Anspruch 3 aufweisend.

## Revendications

1. Une unité de registre à décalage, comprenant : un module d'entrée (310), un premier module de réinitialisation (330), un module de stockage d'énergie (350), un premier module de réinitialisation améliorée (340), un module de commande de sortie (320), une première borne d'entrée (S 1), une deuxième borne d'entrée (S2), une troisième borne d'entrée (S3), une quatrième borne d'entrée (S4), une cinquième borne d'entrée (S5), une sixième borne d'entrée (S6), une borne de sortie de signal de commande de décalage (OUTPUT), et un premier noeud (PU), un deuxième module de réinitialisation (360), une septième borne d'entrée (S7) et une huitième borne d'entrée (S8), un deuxième module de réinitialisation améliorée (370) et une neuvième borne d'entrée (S9), dans laquelle :
une première borne du module de stockage d'énergie (350) est connectée au premier noeud (PU) et une deuxième borne du module de stockage d'énergie (350) est connectée à la borne de sortie de signal de commande de décalage (OUTPUT) ;
le module d'entrée (310) est connecté au premier noeud (PU), à la première borne d'entrée (S1) et à la deuxième borne d'entrée (S2) ;
le module de commande de sortie (320) est connecté au premier noeud (PU), à la troisième borne d'entrée (S3) et à la borne de sortie de signal de commande de décalage (OUTPUT) ;
le premier module de réinitialisation (330) est connecté au premier noeud (PU), à la quatrième borne d'entrée (S4) et à la cinquième borne d'entrée (S5) ; et
le premier module de réinitialisation améliorée (340) est connecté au premier noeud (PU) et à la sixième borne d'entrée (S6), le premier module de réinitialisation améliorée (340) comprend un quatrième transistor (M4), de type P, une électrode de grille et une électrode de drain du quatrième transistor (M4) étant connectées au premier noeud (PU), une électrode de source du quatrième transistor (M4) étant connectée à la sixième borne d'entrée (S6),
le module d'entrée (310) comprend un troisième transistor (M3), de type N, une électrode de grille du troisième transistor (M3) étant connectée à la deuxième borne d'entrée (S2), et une électrode de source du troisième transistor (M3) étant connectée à la première borne d'entrée (S 1) ; ou l'électrode de grille du troisième transistor (M3) est connectée à la première borne d'entrée (S 1), et l'électrode de source du troisième transistor (M3) est connectée à la deuxième borne d'entrée (S2), une électrode de drain du troisième transistor (M3) étant connectée au premier noeud (PU), le module de commande de sortie (320) comprend un cinquième transistor (M5), de type N, une électrode de source du cinquième transistor (M5) étant connectée à la troisième borne d'entrée (S3), une électrode de grille du cinquième transistor (M5) étant connectée au premier noeud (PU), une électrode de drain du cinquième transistor (M5) étant connectée à la borne de sortie de signal de commande de décalage (OUTPUT), le premier module de réinitialisation (330) comprend un sixième transistor (M6), de type N, une électrode de source du sixième transistor (M6) étant connectée au premier noeud (PU), une électrode de drain du sixième transistor (M6) étant connectée à la cinquième borne d'entrée (S5), une électrode de grille du sixième transistor (M6) étant connectée à la quatrième borne d'entrée (S4), la première borne d'entrée (S 1) et la deuxième borne d'entrée (S2) sont une même borne d'entrée ; et
l'unité de stockage d'énergie est un condensateur,
le deuxième module de réinitialisation (360) est connecté à la borne de sortie de signal de commande de décalage (OUTPUT), à la septième borne d'entrée et à la huitième borne d'entrée, dans lequel :
le deuxième module de réinitialisation (360) comprend un premier transistor (M1), de type N, une électrode de grille du premier transistor (M1) étant connectée à la septième borne d'entrée, une électrode de source du premier transistor (M1) étant connectée à la borne de sortie de signal de commande de décalage (OUTPUT), et une électrode de drain du premier transistor (M1) étant connectée à la huitième borne d'entrée ;
le deuxième module de réinitialisation améliorée (370) est connecté au premier noeud (PU), à la neuvième borne d'entrée et à la borne de sortie de signal de commande de décalage (OUTPUT) ; le deuxième module de réinitialisation améliorée (340) comprend un deuxième transistor (M2), de type P, une électrode de grille du deuxième transistor (M2) est connectée au premier noeud (PU), une électrode de drain du deuxième transistor (M2) est connectée à la borne de sortie de signal de commande de décalage (OUTPUT), une électrode de source du deuxième transistor (M2) est connectée à la neuvième borne d'entrée, et, un rapport largeur sur longueur du canal du quatrième transistor (M4) est inférieur à un rapport largeur sur longueur du canal du troisième transistor (M3),
la septième borne d'entrée et la quatrième borne d'entrée (S4) étant une même borne d'entrée et
la cinquième borne d'entrée, la sixième borne d'entrée, la huitième borne d'entrée et la neuvième borne d'entrée étant une même borne d'entrée.

2. Un procédé de commande de l'unité de registre à décalage selon la revendication 1, comprenant :
dans une première phase, le fait d'appliquer une tension d'un niveau de mise en fonctionnement du module d'entrée (310) sur la deuxième borne d'entrée (S2) de façon à mettre en fonctionnement le module d'entrée (310), et le fait d'appliquer un signal impulsionnel du premier niveau sur la première borne d'entrée (S 1) de sorte que le module d'entrée (310) règle la tension au niveau du premier noeud (PU) au premier niveau, et le module d'entrée (310) charge la première borne du module de stockage d'énergie (350) ;
dans une deuxième phase, lorsque la tension au premier noeud (PU) est du premier niveau, le fait de mettre en fonctionnement le module de commande de sortie (320), le fait d'appliquer un premier signal d'horloge sur la troisième borne d'entrée (S3) pour commander le module de commande de sortie (320) de façon à délivrer un signal de commande de décalage par l'intermédiaire de la borne de sortie de signal de commande de décalage (OUTPUT) ; et
dans une troisième phase, le fait d'appliquer un signal de réinitialisation sur la quatrième borne d'entrée (S4) et d'appliquer une tension du deuxième niveau sur la cinquième borne d'entrée (S5) de façon que le premier module de réinitialisation (330) réinitialise la tension au niveau du premier noeud (PU) vers le deuxième niveau, et le premier module de réinitialisation (330) décharge vers la première borne du module de stockage d'énergie (350) ;
dans et après la troisième phase dans une même trame, la tension au niveau du premier noeud (PU) est du deuxième niveau, le fait de mettre le premier module de réinitialisation améliorée (340) en fonctionnement de sorte que le premier module de réinitialisation améliorée (340) fixe la tension au niveau du premier noeud (PU) pour qu'elle soit la tension appliquée sur la sixième borne d'entrée (S6).

3. Un circuit de commande de grille, comprenant une pluralité, en cascade, d'unités de registre à décalage selon la revendication 1.

4. Un dispositif semi-conducteur, comprenant un ou plusieurs des circuits de commande de grille selon la revendication 3.
